# EUROPEAN PATENT SPECIFICATION

(11) **EP 3 203 625 B1**
(45) Date of publication and mention of the grant of the patent: **21.08.2019**
(21) Application number: 16200541.7
(22) Date of filing: 24.11.2016
(51) Int. Cl.: H02M 7/00, H01L 25/07, H01L 25/11, H01G 11/82

(54) **ELECTRIC POWER CONVERSION APPARATUS**
STROMWANDLERVORRICHTUNG
APPAREIL DE CONVERSION DE PUISSANCE ÉLECTRIQUE

(30) Priority: 05.02.2016 JP 2016020370
(43) Date of publication of application: 09.08.2017
(73) Proprietor: Hitachi, Ltd., Tokyo (JP)
(72) Inventor: MAE, Kentarou, Chiyoda-ku, Tokyo 100-8280 (JP); KATAGIRI, Masaru, Chiyoda-ku, Tokyo 100-8280 (JP); YASUDA, Yosuke, Chiyoda-ku, Tokyo 100-8280 (JP)
(74) Representative: Mewburn Ellis LLP

(56) References cited:
- DE-A1- 10 006 505
- DE-A1- 19 634 823
- JP-A- 2001 094 035
- JP-A- 2001 156 506
- JP-A- 2010 087 400
- US-A- 5 537 074
- US-A- 6 021 060

## Description

### BACKGROUND OF THE INVENTION

The present invention relates to a structure of an electric power conversion apparatus provided with a switching module, a smoothing capacitor, and a bus bar.

When an electric power conversion apparatus using a switching module uses a high voltage power source, a surge voltage during switching may cause a problem. In order to suppress this surge voltage, the inductance of the main circuit may be reduced, and it would be effective to use multiple smoothing capacitors and multiple switching modules connected in parallel and use a flat plate shaped bus bar disposed in proximity. JP 2012-105382 A discloses such structure.

In a main circuit of an electric power conversion apparatus using multiple smoothing capacitors and multiple switching modules connected in parallel just like the one disclosed in JP 2012-105382 A, an electric current imbalance between multiple terminals of switching modules may cause a problem. This is because when the terminal electric current of the switching module and the smoothing capacitor partially increases, heat generation occurs in a concentrated manner and this is likely to degrade solder and the like in a time shorter than expected.

The factors that affect the electric current imbalance includes variations of inductances potentially exist in the switching modules, the smoothing capacitors, and the bus bar, and the wiring inductance mainly due to the bus bar is a major cause. JP 2000-60126 A indicates that cutouts are provided in a bus bar so that electric current paths flowing from a capacitor to multiple terminals of switching modules have the same length. JP 2012-110099 A indicates that the same number of switching modules and smoothing capacitors are arranged in parallel, so that electric current paths flowing from each capacitor to multiple terminals of switching modules have the same length.

Furthermore, US 6,021,060 A, which is considered as the closest prior art, discloses a power converter device such as a 2-level inverter, a 2-level converter, etc. for executing power conversion between a direct current (DC) and a 2-level alternating current (AC). In particular, a technology of reducing internal inductances of the power converter device is disclosed.

US 5,537,074A discloses a power output switching circuit for use in high current and high frequency applications. The output circuit provides a series of geometrically symmetric parallel spaced semi-conductor converters arranged such that the voltage for each semiconductor output device is substantially equal and minimal for each device. In this way, each device exhibits substantially the same impedance, such that circuit performance is largely a function of instrinsic device characteristics, and substantially independent of cross coupling and other external influences.

DE 100,06,505 A1 discloses a power semiconductor module including a number of parallel IGBT-chips with their emitter conductor paths, base conductor paths, collector conductor paths at least partially provided in common, with a slit provided in one of these conductor paths. The conductor paths are applied to a ceramics substrate, with the slit provided simultaneous with the formation of the conductor paths, or provided subsequently via an etching process.

JP 2001 094035 A discloses a high-density mouting type semiconductor device, in which impedances are made almost identical. This semiconductor device is provided with a plurality of conductive metal plates, which are formed on a semiconductor substrate having electrodes. a plurality of semiconductor chips, which are connected with the metal plates, and impedance equalizing means which make the lengths of current paths formed between the chips and the metal plates nearly identical. Thereby the impedances of the semiconductor chips and the electrodes are balanced, so that a high density mounting type semiconductor device which does not generate oscillations can be obtained.

JP 2001 156506 A discloses a power distributor which is small in size and yet the uniformity and the symmetry in the amplitude distribution of a current flowing through the output lines is enhanced. The power distributor is configured with a microstrip line formed on a dieletric substrate (or semiconductor substrate), a strip conductor, an inputline, output lines and a branch. Notches are formed in opposing edges of the output lines of the strip conductor. The notches act to cut off a path for a current with large amplitude and shifting the path of the current with the large amplitude up to a tip position of the notches so as to uniformize the amplitude distribution of the current around the exits of the output lines. By simulating, for example, the current distribution by taking various conditions into account, the position, depth, and the width of the notches can be decided.

JP 2010 087400 A discloses a semiconductor device which efficiently radiates heat while keeping current balance of respective semiconductor elements, in a semiconductor device with a plurality of semiconductor elements connected in parallel with one another. In an internal connection part where a plurality of semiconductor circuit boards, each having a semiconductor element mounted thereon, are electrically connected to one another. This power semiconductor device has a slit as a current path length uniformizing means, and a bent part with an end bent upwards in an L-shaped form as a heat radiation means.

DE 196,34,823 A1 discloses a low-inductances type high-resistance diode arrangement comprising several pancake- or disc-type diodes and two bus-bars arranged electrically in parallel and tensioned with a block. The thickness of the two bus-bars are dissimilar and the thickness of one of the bus-bars is selected in such a way that the bus-bar is mechanically flexible. The thicker bus-bar is arranged between the lower amd upper spatially adjacent diodes and an additional mechanically flexible bus-bar is provided, with the mechanically flexible bus-bars shaped so that they form a common electrical terminal. The bus-bars are provided with slots so that in the direction of current flow, an approximately equal-value DC resistance is formed upsteam of each diode.

### SUMMARY OF THE INVENTION

As described in FIG. 7 of JP 2000-60126 A, the bus bar structure of JP 2000-60126 A has a less electric current imbalance between switching devices connected in parallel than a structure without any slit, but the bus bar structure of JP 2000-60126 A has various lengths of electric current paths, and does not provide a sufficient level of reduction effect of the variation of electric currents. In JP 2000-60126 A, electric current paths in the bus bar is considered to connect a single capacitor with multiple switching devices connected in parallel, but in the structure for connecting multiple capacitors and multiple switching devices, suppression of a deviation of electric currents between terminals of capacitors and a deviation of electric currents between terminals of switching devices are not considered.

FIG. 1 and FIG. 8 of JP 2012-110099 A disclose a structure having the same number of switching modules and capacitors and capable of making the electric current paths between the switching modules and the capacitors to have the same length, but in a case where the number of switching modules provided in parallel is reduced in accordance with the performance required for the electric power conversion apparatus, this results in a variation of the lengths of the electric current paths between the switching modules and the capacitors, and accordingly, a deviation of electric currents occurs between terminals of the capacitors, and a deviation of electric currents also occurs between the terminals of the switching devices.

In view of this issue, it is an object to solve the variation in the inductances of the bus bars between multiple terminals of the switching modules and between multiple terminals of the capacitors, and equalize the distribution of electric currents flowing through multiple terminals of the switching modules and the smoothing capacitors.

To achieve the above object, the present invention provides an electric power conversion apparatus according to claim 1.

The variation in the inductances of the bus bars between switching module terminals can be solved, and the distribution of electric currents flowing through multiple terminals of the switching modules and the smoothing capacitors is equalized. As a result, the reliability of the electric power conversion apparatus can be improved.

Other objects, features and advantages of the invention will become apparent from the following description of the embodiments of the invention taken in conjunction with the accompanying drawings.

### BRIEF DESCRIPTION OF THE DRAWING

FIG. 1 illustrates an entire configuration of an electric power conversion apparatus according to a first embodiment of the present invention;
FIG. 2 illustrates an electric circuit of an electric power conversion apparatus according to the first to fourth embodiments of the present invention;
FIG. 3 illustrates an internal configuration of a switching module according to the first to fourth embodiments of the present invention;
FIG. 4 illustrates an entire configuration of an electric power conversion apparatus according to the first to fourth embodiments of the present invention when it is seen from a side surface;
FIG. 5 illustrates electric current paths of a P bus bar according to the first embodiment of the present invention;
FIG. 6 illustrates electric current paths of a P bus bar without any slit;
FIG. 7 illustrates electric current paths of a P bus bar in which an arrangement of terminals connected to a smoothing capacitor is horizontally asymmetrical;
FIG. 8 illustrates electric current paths of a P bus bar which has no slits and in which an arrangement of terminals connected to a smoothing capacitor is horizontally asymmetrical;
FIG. 9 illustrates electric current paths of an M bus bar according to the first and second embodiments of the present invention;
FIG. 10 illustrates another electric current path of an M bus bar according to the first and third embodiments of the present invention;
FIG. 11 illustrates electric current paths of an N bus bar according to the first embodiment of the present invention;
FIG. 12 illustrates substantial electric current paths of an N bus bar according to the first embodiment of the present invention;
FIG. 13 illustrates an entire configuration of an electric power conversion apparatus according to the first embodiment of the present invention in a case where two terminal switching modules are used;
FIG 14 illustrates an entire configuration of an electric power conversion apparatus according to a second embodiment of the present invention;
FIG. 15 illustrates an electric current path of a P bus bar according to the second embodiment of the present invention;
FIG. 16 illustrates electric current distribution and electric current paths in a case where there is no slit in the P bus bar according to the second embodiment of the present invention;
FIG. 17 illustrates electric current paths of an N bus bar according to the second embodiment of the present invention;
FIG. 18 illustrates substantive electric current paths of the N bus bar according to the second embodiment of the present invention;
FIG. 19 illustrates an entire configuration of an electric power conversion apparatus according to a third embodiment of the present invention;
FIG. 20 illustrates electric current paths of the P bus bar according to the third embodiment of the present invention;
FIG. 21 illustrates substantive electric current paths of the P bus bar according to the third embodiment of the present invention;
FIG. 22 illustrates electric current paths of an M bus bar according to the third and fourth embodiments of the present invention;
FIG 23 illustrates electric current paths of an N bus bar according to the third embodiment of the present invention;
FIG. 24 illustrates substantive electric current paths of the N bus bar according to the third embodiment of the present invention;
FIG. 25 illustrates an entire configuration of an electric power conversion apparatus according to the third embodiment of the present invention in a case where switching modules 13, 14 are considered;
FIG 26 illustrates an entire configuration of an electric power conversion apparatus according to a fourth embodiment of the present invention;
FIG. 27 illustrates electric current paths of a P bus bar according to the fourth embodiment of the present invention;
FIG. 28 illustrates electric current paths of the P bus bar according to the fourth embodiment of the present invention;
FIG. 29 illustrates electric current paths of an N bus bar according to the fourth embodiment of the present invention; and
FIG. 30 illustrates substantive electric current paths of the N bus bar according to the fourth embodiment of the present invention.

### DESCRIPTION OF EMBODIMENTS

Multiple embodiments of the present invention will be explained with reference to the following drawings.

### [First embodiment]

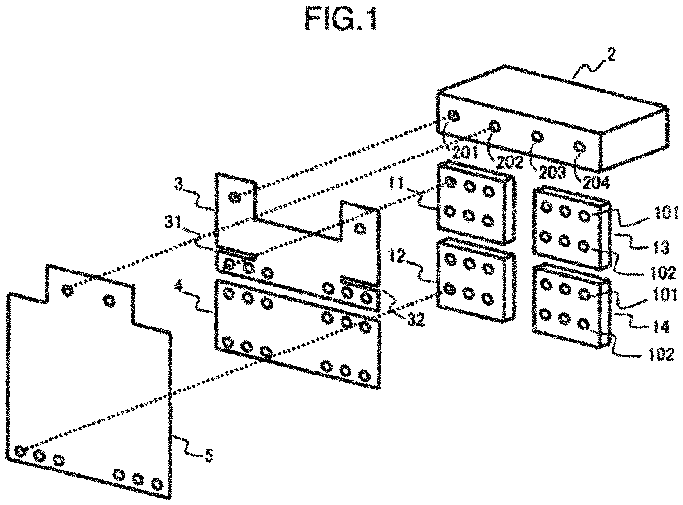

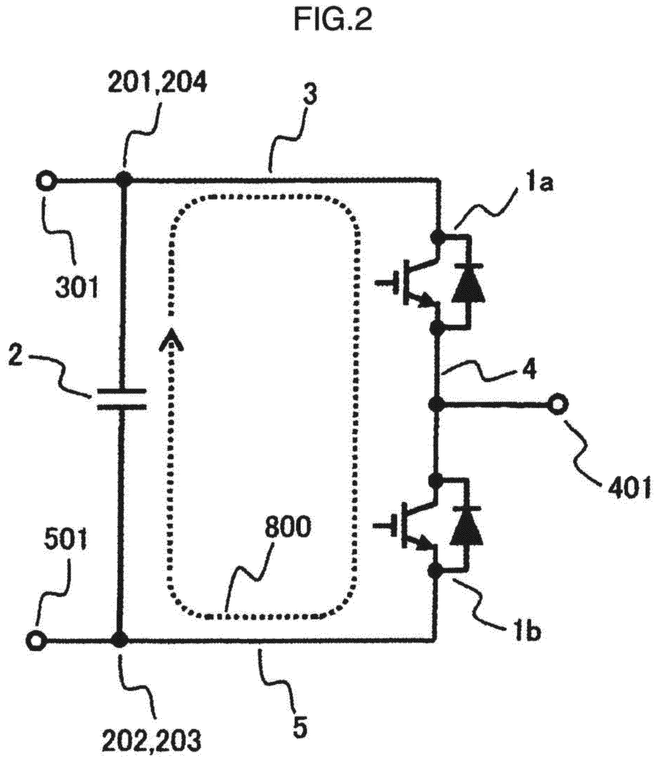

An electric power conversion apparatus to which the present invention pertains includes, as a configuration for a single phase, switching modules 11 to 14, a smoothing capacitor 2, a P bus bar (positive side bus bar) 3, an M bus bar (alternate current bus bar) 4, and an N bus bar (negative side bus bar) 5, as illustrated in FIG 1. The electric circuit for the single phase of the electric power conversion apparatus is as illustrated in FIG. 2, and is configured so that a direct current voltage is applied to input terminals 301, 501, and a predetermined voltage is output to an output terminal 401. For example, in a case where an inverter circuit for outputting a three-phase alternate current voltage is configured as an electric power conversion apparatus, three configurations as shown in FIG 1, each of which constitutes a single phase, are combined to realize the inverter circuit. In a case where a converter circuit is for converting a single phase alternate current voltage into a direct current voltage is constituted as an electric power conversion apparatus, two configurations as shown in FIG. 1, each of which constitutes a single phase, are combined to realize the converter circuit.

FIG 2 illustrates a circuit constituted by a device for a single phase as illustrated in FIG 1. In the circuit as illustrated in FIG 2, the upper arm switching device 1a and the lower arm switching device 1b performs open and close operation in accordance with a predetermined command signal, and the upper arm switching device 1a and the lower arm switching device 1b are turned ON alternately, so that a high voltage side voltage and a low voltage side voltage of a direct current voltage is output alternately to the output terminal. At an instance when the switching device of the upper and lower arms opens or closes, an electric current flows in the path indicated by an electric current path 800. The present invention relates to an equalization of the electric current flowing in this electric current path 800.

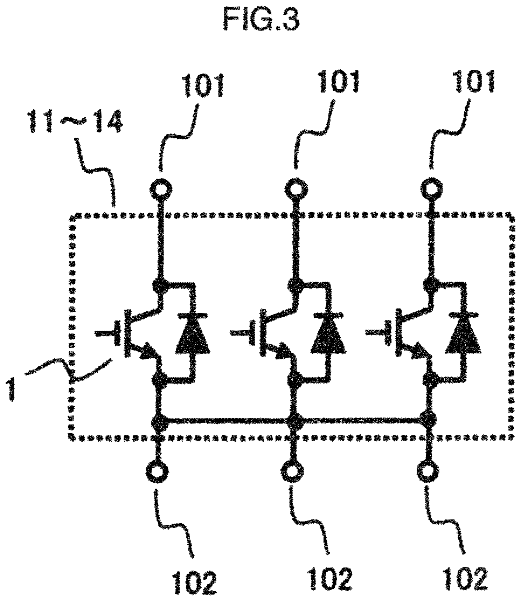

In the present embodiment, the upper arm of the circuit is constituted by the switching modules 11, 13, and the lower arm of the circuit is constituted by the switching modules 12, 14. The number of parallel terminals of the switching modules 11 to 14 is determined in accordance with factors such as an electric current capacity and an internal inductance. As the number of parallel terminals increases, the capacity of the electric current can be increased, and the inductance can be reduced. In the present embodiment, as illustrated in FIG. 3, the switching modules 11 to 14 include three switching devices 1 therein, and the three switching devices 1 are disposed in parallel, and are connected to collector terminals 101 and emitter terminals 102. In the upper arm, the switching modules 11, 13 are connected in parallel, and therefore, totally six switching devices 1 are connected in parallel. In the lower arm, likewise, totally six switching devices 1 are connected in parallel. When the distribution of electric currents of the switching devices 1 connected in parallel is more equal, degradation of solder and the like due to heat generation concentration can be prevented, and the reliability of the electric power conversion apparatus can be improved.

The smoothing capacitor 2 is configured to smooth the direct current voltage applied to the input terminals 301, 501. The number of parallel terminals is determined in accordance with factors such as an electric current capacity and an internal inductance. As the number of parallel terminals increases, the capacity of the electric current can be increased, and the inductance can be reduced. In the present embodiment, for example, a two-parallel smoothing capacitor is used, which includes P-pole terminals 201, 204 disposed at the outside and N-pole terminals 202, 203 disposed at the inside. The smoothing capacitor is constituted by multiple internal capacitors connected in parallel, and therefore, like the switching module, the distribution of the electric currents can be equalized even in the smoothing capacitor.

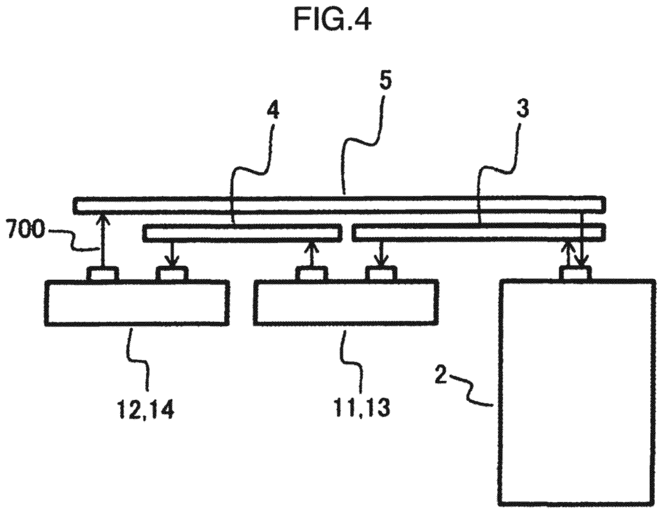

The P bus bar 3, an M bus bar 4, and the N bus bar 5 are connected to the switching modules 11 to 14 and the smoothing capacitor 2 to constitute the electric current path 800. The P bus bar 3 includes terminals 311, 312 connected to the P-pole terminals 201, 204 of the smoothing capacitor 2 and terminals 321, 322 connected to the collector terminals 101 of the switching modules 11, 13 constituting the upper arm. The M bus bar 4 includes connection terminals for the emitter terminals 102 of the switching modules 11, 13 constituting the upper arm and connection terminals for the collector terminals 101 of the switching modules 12, 14 constituting the lower arm. The N bus bar 5 includes connection terminals for the N-pole terminals 202, 203 of the smoothing capacitor 2 and connection terminals for the emitter terminals 102 of the switching modules 12, 14 constituting the lower arm. FIG. 4 illustrates, when seen from the side surface, an entire configuration of the switching modules 11 to 14, the smoothing capacitor 2, the P bus bar 3, the M bus bar 4, and the N bus bar 5 which are connected with each other. The P bus bar 3, the M bus bar 4, and the N bus bar 5 are wide conductive bodies, and are arranged in proximity to each other as shown in FIG. 4 so as to cancel the magnetic flux generated by the passed current and contribute to reducing the inductance of the circuit. The shapes of the P bus bar 3, the M bus bar 4, and the N bus bar 5 greatly affect the distribution of the electric current flowing through the switching modules 11 to 14 and the smoothing capacitor 2 in the electric current path 800. The bus bar electric current is less likely to flow when the path length is longer, and is more likely to flow when the path length is shorter. Therefore, in order to equalize the distribution of the electric current, the bus bar is preferably made into such a shape that the path lengths are equal.

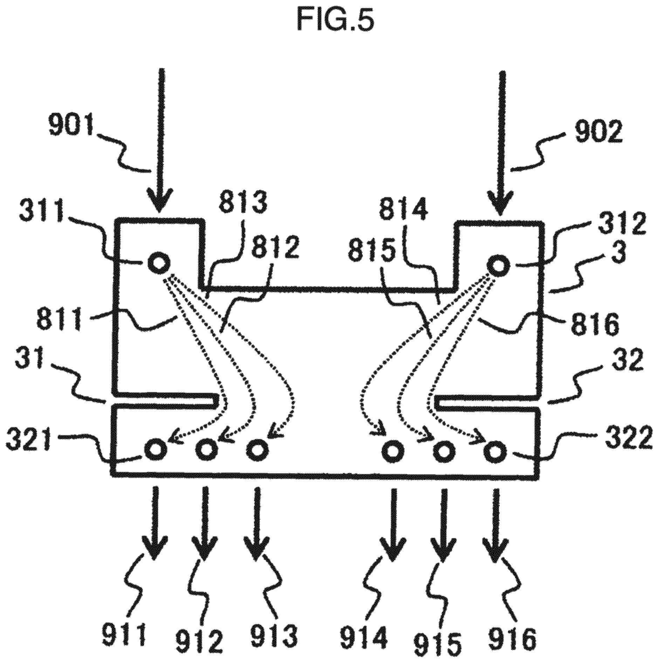

FIG. 5 illustrates electric current paths of a P bus bar. At one side of the P bus bar 3, the P bus bar 3 as illustrated in FIG. 5 includes the terminals 311, 312 connected to the P-pole terminals 201, 204 of the smoothing capacitor 2, and at the other side of the P bus bar 3, the P bus bar 3 includes the terminals 321, 322 connected to the collector terminals 101 of the switching modules 11, 13 constituting the upper arm. The terminal 311 and the terminal 312 are disposed at the horizontally symmetrical positions at one side of the P bus bar, and in the present embodiment, the terminal 311 and the terminal 312 are disposed at the outside. The P bus bar 3 is provided with slits 31, 32. The slit 31 is disposed at the position where the slit 31 crosses a straight line which is one of the lines connecting the terminal 311 and multiple terminals 321 and which has the shortest distance (a straight line connecting the terminal 311 and the terminal 321 at the most outside position). Likewise, the slit 32 is disposed at the position where the slit 32 crosses a straight line which is one of the lines connecting the terminal 312 and multiple terminals 322 and which has the shortest distance (a straight line connecting the terminal 312 and the terminal 322 at the most outside position). In the present embodiment, the slits 31, 32 are disposed at the outside of the P bus bar. In the P bus bar 3, the paths of the bus bar electric currents flowing between the terminals are paths 811 to 816. In the P bus bar 3 having slits as shown in FIG 5, the lengths of the paths 811 to 816 are substantially equal. Therefore, the magnitudes of the capacitor electric currents 901, 902 flowing to the smoothing capacitor 2 can be made into substantially the same magnitude, and further, the magnitudes of the switching module electric currents 911 to 916 flowing to the switching devices 1 in the switching modules 11, 13 can be made into substantially the same magnitude. In the present embodiment, for example, the slit is constituted by a space. Alternatively, the slit portion may be made of a material having a high electric insulating property.

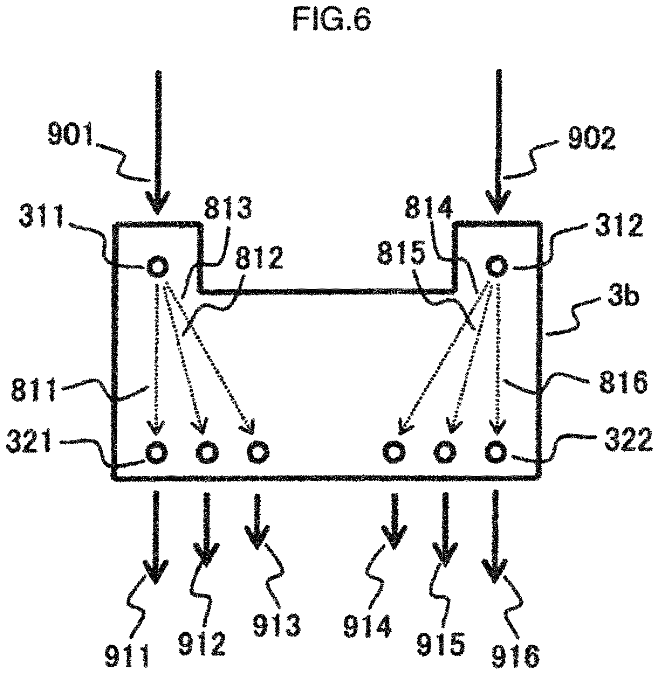

The advantages of the slits 31, 32 is shown by comparing the slits 31, 32 with a P bus bar 3b without any slit as shown in FIG. 6. In the P bus bar 3b, the paths of the bus bar electric currents are 811 to 816 as shown in FIG. 6. The paths 811 to 813 have slightly longer path lengths in the order of 811, 812, and 813, and the paths 814 to 816 have slightly longer path lengths in the order of 816, 815, and 814, so that the path lengths of the bus bar electric currents are unequal between the terminals. Therefore, the switching module electric currents 911 to 916 are unequal between the terminals, and have such an electric current distribution that the switching module electric current 911 is the largest followed by 912 and 913 in this order, and switching module electric current 916 is the largest followed by 915 and 914 in this order.

On the other hand, in the P bus bar 3 as shown in FIG. 5, the paths 811 to 816 of the bus bar electric currents make a detour around the slits 31, 32, so that the path lengths become substantially equal, and this can make substantially equal electric currents 911 to 916 flowing to the switching modules.

The slit width may be about several millimeters. The longer the slit length is, or the closer to the terminals 321, 322 the slit position is, the switching module electric currents 911, 916 decrease. Therefore, the optimum slit lengths and slit positions may be determined in accordance with the dimension of the target P bus bar.

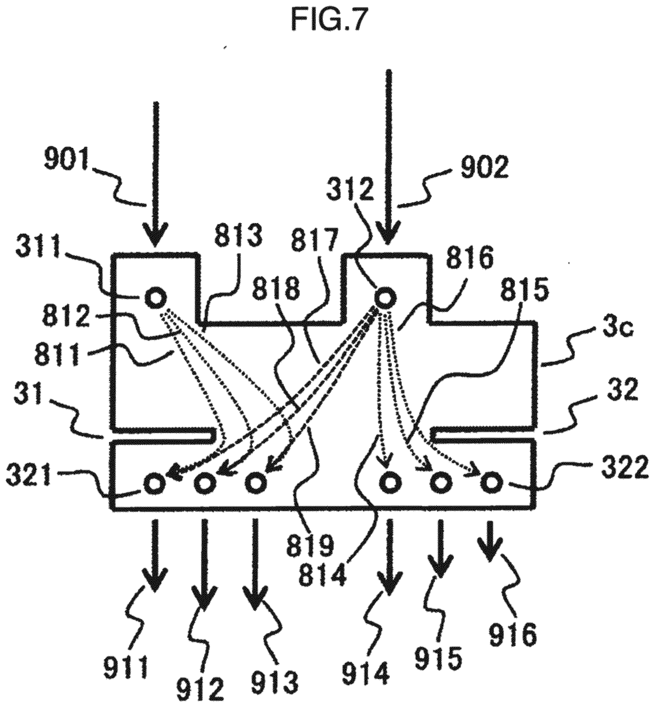

The advantage as to why the terminals 311, 312 of the P bus bar connected to the smoothing capacitor 2 are the horizontally symmetrical positions on the P bus bar is shown by comparing the arrangement of these terminals with horizontally asymmetrical terminals on a P bus bar 3c as shown in FIG 7. As illustrated in FIG. 7, in the P bus bar 3c, the paths of the bus bar electric currents flowing between the terminals are paths 811 to 819.

When the capacitor electric currents 901, 902 are considered, a capacitor electric current 901 flowing to the terminal 311 passes through the paths 811 to 813 and flow into only the terminal 321, but the capacitor electric current 902 flowing to the terminal 312 passes through the paths 814 to 819 and flow into the terminal 321 and the terminal 322, and therefore, the distribution of the capacitor electric current 902 is higher, which makes the capacitor electric currents 901, 902 be unequal. The terminal 311 is disposed outside of the P bus bar, and therefore, the capacitor electric current 901 flows into only the terminal 321 of which distance is short, but the terminal 312 is disposed at the central side of the P bus bar, and therefore, the distance from the terminal 312 to each terminals 321, 322 becomes relatively short, and the capacitor electric current 902 flows into each of the terminals 321, 322, and this produces a deviation of the capacitor electric currents.

When the switching module electric currents 911 to 916 are considered, only a portion of the capacitor electric current 902 flows into the switching module electric currents 914 to 916 via the paths 814 to 816, but the entire capacitor electric current 901 and a portion of the capacitor electric current 902 flow into the switching module electric currents 911 to 913 via the paths 811 to 813 and the paths 817 to 819, and therefore, the summation of the switching module electric currents 911 to 913 is larger than the summation of the switching module electric currents 914 to 916, so that the switching module electric currents 911 to 916 are unequal.

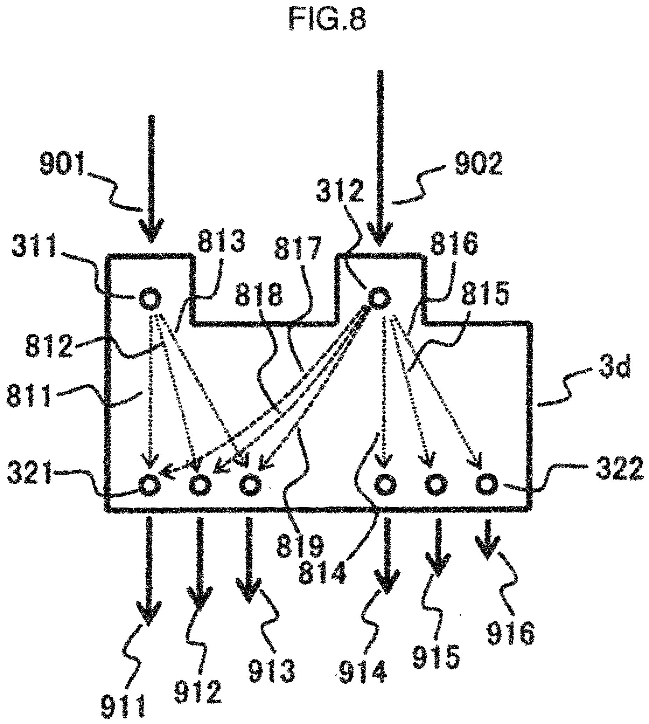

The P bus bar 3d obtained by removing the slits 31, 32 from the P bus bar 3c is shown in FIG. 8. In the Pbus bar 3d, the paths of the bus bar electric currents are 811 to 819. As shown in FIG. 8, on the Pbus bar 3d, the distribution of the capacitor electric currents 901, 902 and the switching module electric currents 911 to 916 is unequal.

On the other hand, on the Pbus bar 3 as shown in FIG. 5, the terminal 311 and the terminal 312 are arranged at the outsides of the P bus bar, and accordingly, the paths 817 to 819 of the bus bar electric currents do not exist, and the lengths of the paths 811 to 816 of the bus bar electric currents are substantially equal, and therefore, the variation between the capacitor electric currents 901, 902 and the variation of the switching module electric currents 911 to 916 can be reduced.

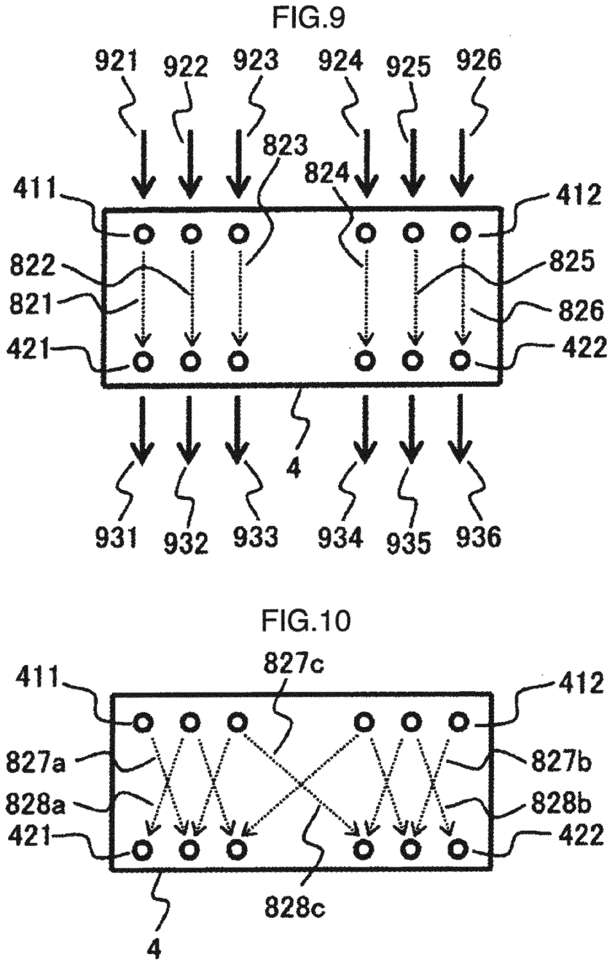

The M bus bar 4 as shown in FIG. 9 includes terminals 411, 412 connected to the emitter terminals 102 of the switching modules 11, 13 constituting the upper arm and terminals 421, 422 connected to the collector terminals 101 of the switching modules 12, 14 constituting the lower arm. On the M bus bar 4, the paths of the bus bar electric currents flowing between the terminals 411, 412 and the terminals 421, 422 are expressed by paths 821 to 826, and the lengths of the paths thereof are substantially equal.

FIG. 10 illustrates cross current paths to adjacent terminals of each terminal of the M bus bar. In a case where paths 827a, 828a from the terminal 411 to the terminal 421 are considered in FIG. 10, these paths 827a, 828a have the same path length, and therefore, the exchange of the electric currents between terminals adjacent to each other in the horizontal direction is substantially zero. This indicates that any cross current does not occur in the horizontal direction between the terminal 411 and the terminal 421. The lengths of paths 827b and 828b and paths 827c and 828c between the terminals 412 and the terminals 422, between the terminals 411 and the terminals 422, and between the terminals 412 and the terminals 421 are equal, and therefore, likewise, this indicates that any cross current does not occur in the horizontal direction. Since any cross current does not occur between any of the terminals adjacent to each other in the horizontal direction, the paths between the terminals 411 and the terminals 421 and between the terminals 412 and 422 may be deemed as having only the paths 821 to 826 as shown in FIG. 9.

Therefore, the magnitudes of the switching module electric currents 921 to 926 flowing into the terminals 411, 412 and the switching module electric currents 931 to 936 flowing into the terminals 421, 422 can be made into substantially the same.

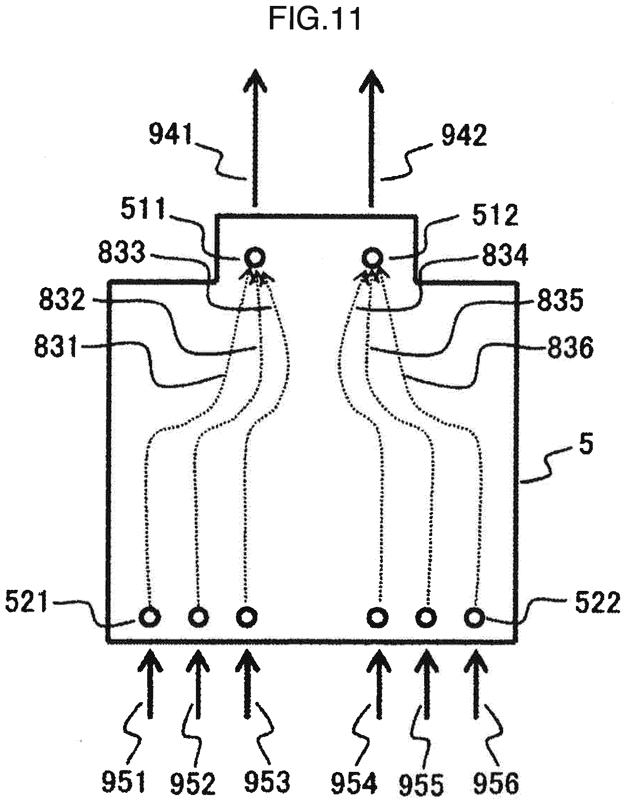

Subsequently, FIG 11 illustrates electric current paths of an N bus bar. As illustrated in FIG. 11, the N bus bar 5 includes terminals 511, 512 connected to the N-pole terminals 202, 203 of the smoothing capacitor 2 and terminals 521, 522 connected to the emitter terminal 102 of the switching modules 12, 14 constituting the lower arm. The terminals 511, 512 are disposed at horizontally symmetrical positions on the N bus bar, and in the present embodiment, the terminals 511, 512 are disposed at the inside of the N bus bar.

Portions of electric current paths 831 to 836 of the N bus bar 5 are disposed along electric current paths 811 to 8 16, 821 to 826 of the P bus bar 3 and the M bus bar 4 disposed in proximity to each other as illustrated in FIG. 4. In a section in which the electric current paths extend, the magnetic fields formed by the bus bar electric currents cancel each other, so that the inductance of the electric current path becomes substantially zero. The electric current has a property of more likely to flow in a path of which inductance is small. Therefore, the electric current paths 831 to 836 of the N bus bar 5 are not simply made into a straight line shape between the terminals 511, 512 and the terminals 521, 522, and as illustrated in FIG 11, the electric current paths 831 to 836 of the N bus bar 5 are paths extending along the electric current paths 811 to 816, 821 to 826 of the P bus bar 3 and the M bus bar 4.

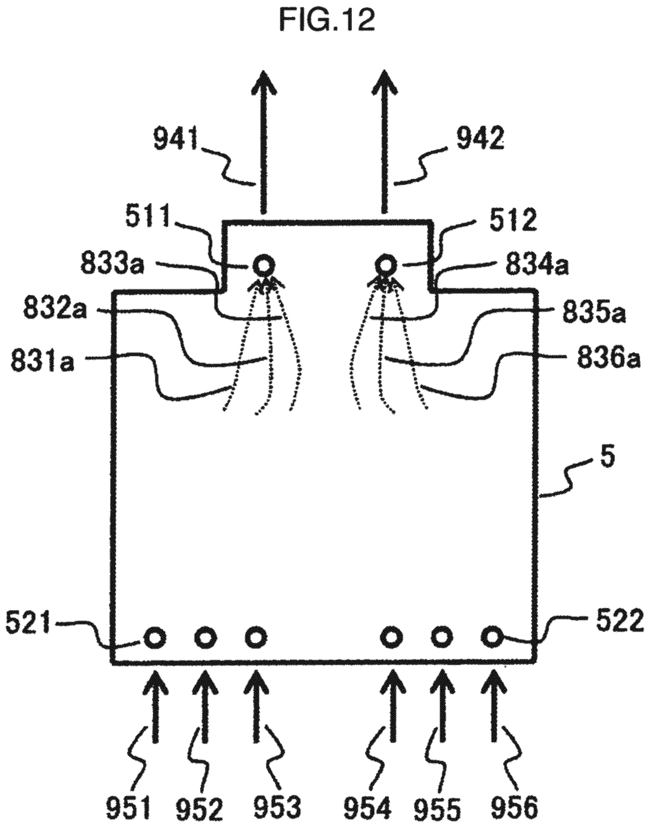

FIG. 12 illustrates substantive paths contributing the inductance in the electric current paths 831 to 836. The substantive path is given by subtracting a section in which the inductance becomes substantially zero. As illustrated in FIG. 12, the path lengths of the substantive paths 831a to 836a are substantially equal, and therefore, the variation of the magnitudes of the capacitor electric currents 941, 942 and the variation of the magnitudes of the switching module electric currents 951 to 956 can be reduced.

As described above, the P bus bar 3, the M bus bar 4, and the N bus bar 5 as illustrated in the present embodiment are used, so that even in a configuration in which six switching devices are connected in parallel, the variation of the electric currents flowing in the switching devices in the switching modules 11 to 14 and the electric currents flowing in the internal capacitors in the smoothing capacitors 2 can be reduced, and the reliability of the electric power conversion apparatus can be improved.

In the present embodiment, as illustrated in FIG. 4, for example, a case where the P bus bar 3 and the M bus bar 4 are disposed on substantially the same plane has been explained, but the bus bars may be disposed in proximity to each other, and may not be necessarily disposed in the same plane. The P bus bar and the N bus bar are disposed in such an order that the P bus bar is disposed closer to the switching modules 11, 12, 13, 14. Alternatively, the N bus bar and the P bus bar may be disposed in such an order that the N bus bar is disposed closer to the switching modules 11, 12, 13, 14.

The direction of the switching modules 11 to 14 in FIG. 1 may be flipped upside down, so that the terminals 101, 102 are interchanged with each other, and the P bus bar 3 is used as the N bus bar, and the N bus bar 5 is used as the P bus bar. Even in this case, the following advantage can be obtained: the variation of the electric currents flowing in the switching devices in the switching modules 11 to 14 and the electric currents flowing in the internal capacitors in the smoothing capacitors 2 can be reduced.

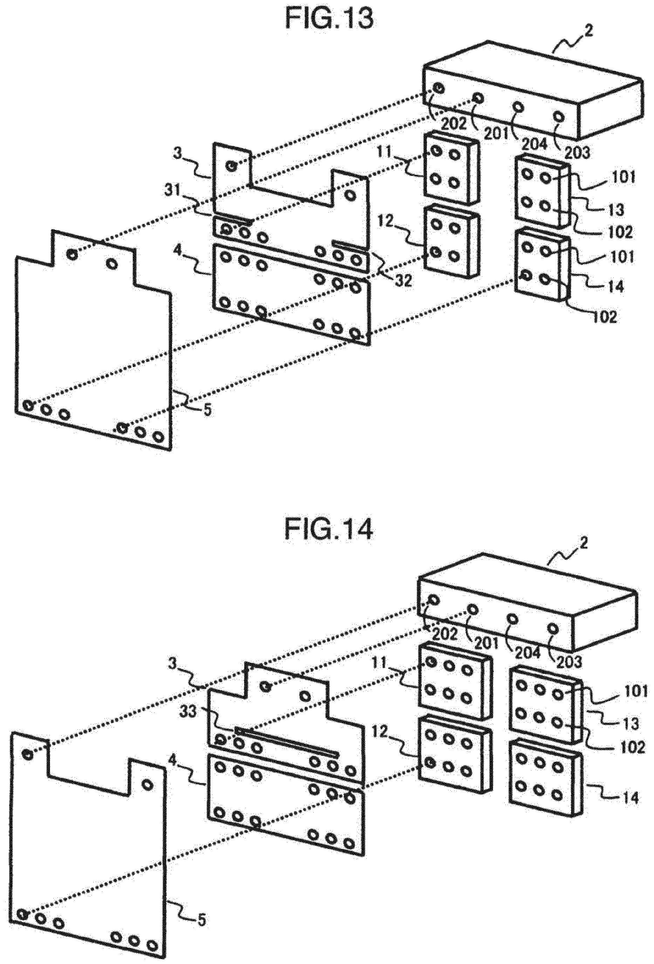

In the present embodiment, the switching module having three parallel switching devices is used. Alternatively, the switching module constituted by two parallel switching devices may be used as illustrated in FIG 13. In this case, the number of terminals 321, 322 of the P bus bar, terminals 411, 412, 421, 422 of the M bus bar, and terminals 521, 522 of the N bus bar may match the number of collector terminals 101 and emitter terminals 102 of the switching modules. As illustrated in FIG. 13, the bus bar for the three parallel switching modules as illustrated in the present embodiment is applied to the two parallel switching modules as it is, and even in a case where the number of parallel switching modules is changed in accordance with the required electric current capacity, the same bus bar can be applied without requiring any change in the design.

### [Second embodiment]

As illustrated in FIG. 14, a single phase of an electric power conversion apparatus according to the second embodiment includes switching modules 11 to 14, a smoothing capacitor 2, a P bus bar 3, an M bus bar 4, and an N bus bar 5. The difference from the first embodiment lies in that the configurations of the smoothing capacitor 2, the P bus bar 3, and the N bus bar 5 are different. In the following explanation, the issues common to the first embodiment will not be explained.

The present embodiment pertains to two-parallel smoothing capacitor 2 including P-pole terminals 201, 204 arranged at the inside and N-pole terminals 202, 203 arranged at the outside.

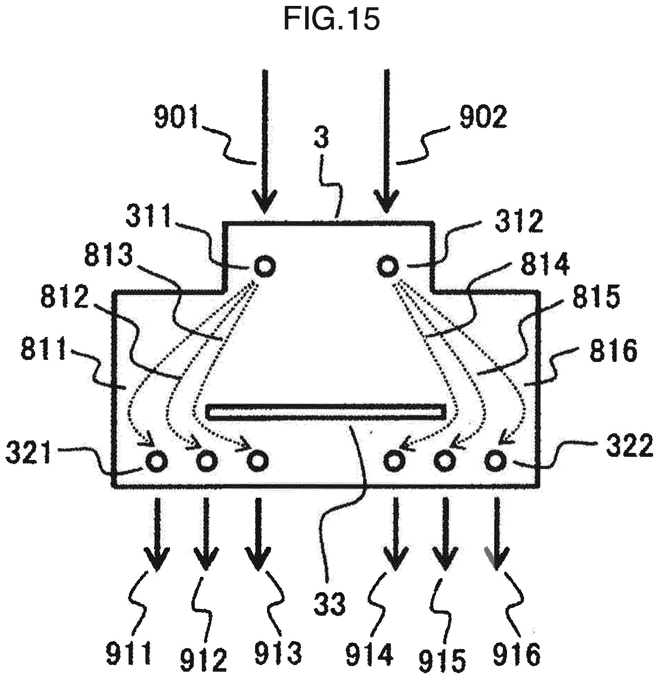

The P bus bar 3 as illustrated in FIG. 15 includes terminals 311, 312 connected to P-pole terminals 201, 204 of the smoothing capacitor 2 and terminals 321, 322 connected to collector terminals 101 of the switching modules 11, 13. The terminals 311, 312 are disposed at horizontally symmetrical positions on the P bus bar, and in the present embodiment, the terminals 311, 312 are disposed at the inside of the P bus bar. The P bus bar 3 is provided with a slit 33 in an area crossing one of straight lines which connect the terminal 311 and each terminal 321 and of which distance is the shortest (a straight line connecting the terminal 311 and the terminal 321 at the most inside position) and one of straight lines which connect the terminal 312 and each terminal 322 and of which distance is the shortest (a straight line connecting the terminal 312 and the terminal 321 at the most inside position), and in the present embodiment, the slit 33 is configured at the inside position of the P bus bar. On the P bus bar 3, the paths of the bus bar electric currents are paths 811 to 816 as illustrated in FIG 15. The lengths of the paths 811 to 816 are substantially equal, and therefore, the magnitudes of the capacitor electric currents 901, 902 and the switching module electric currents 911 to 916 can be made into substantially the same magnitude.

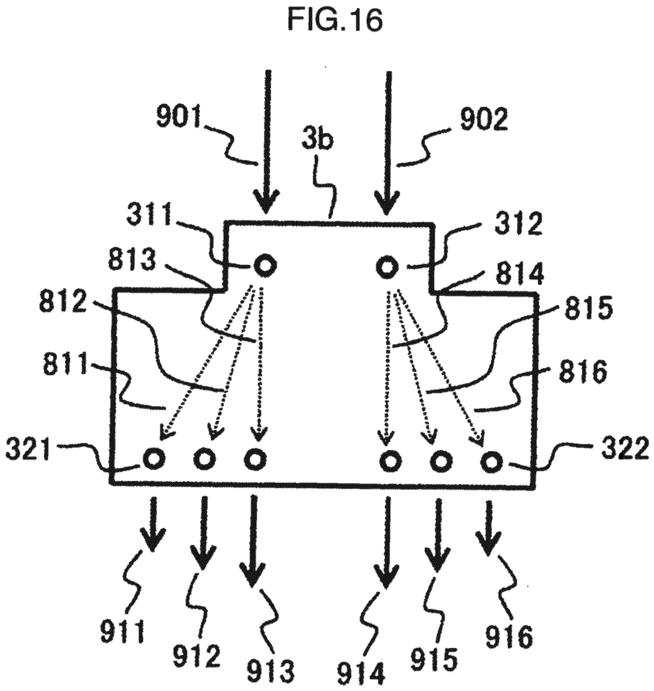

The advantage of the slit 33 is shown by comparing the slit 33 with a P bus bar 3b without any slit as illustrated in FIG 16. As illustrated in FIG 16, on the P bus bar 3b, the paths of the bus bar electric currents are paths 811 to 816. The paths 811 to 813 have longer electric current path lengths in the order of 813, 812, and 811, and the paths 814 to 816 have longer electric current path lengths in the order of 814, 815, and 816, and the path lengths of the bus bar electric currents are unequal for each terminal. Therefore, the switching module electric currents 911 to 916 are unequal, and have such an electric current distribution that the switching module electric current 913 is the largest followed by 912 and 911 in this order, and switching module electric current 914 is the largest followed by 915 and 916 in this order.

On the other hand, on the P bus bar 3 as illustrated in FIG 15, the paths 811 to 816 of the bus bar electric currents make a detour around the slit 33, so that the path lengths become substantially equal, and this can make substantially equal electric currents 911 to 916 flowing to the switching modules.

The slit width may be about several millimeters. The longer the slit length is, or the closer to the terminals 321, 322 the slit position is, the switching module electric currents 913, 914 decrease. Therefore, the optimum slit lengths and slit positions may be determined in accordance with the dimension of the target P bus bar.

The advantage as to why the terminals 311, 312 connected to the smoothing capacitor 2 are the horizontally symmetrical positions on the P bus bar 3d is shown by comparing the arrangement of these terminals with horizontally asymmetrical terminals on a P bus bar 3d. As explained in the first embodiment, on the P bus bar 3d, the distributions of the capacitor electric currents 901, 902 and the switching module electric currents 911 to 916 are unequal. On the other hand, on the P bus bar 3 as illustrated in FIG. 15, the paths 817 to 819 of the bus bar electric currents do not exist, and the lengths of the paths 811 to 816 of the bus bar electric currents are equal, and therefore, the distributions between the capacitor electric currents 901, 902 and the variation of the switching module electric currents 911 to 916 can be made into equal distributions.

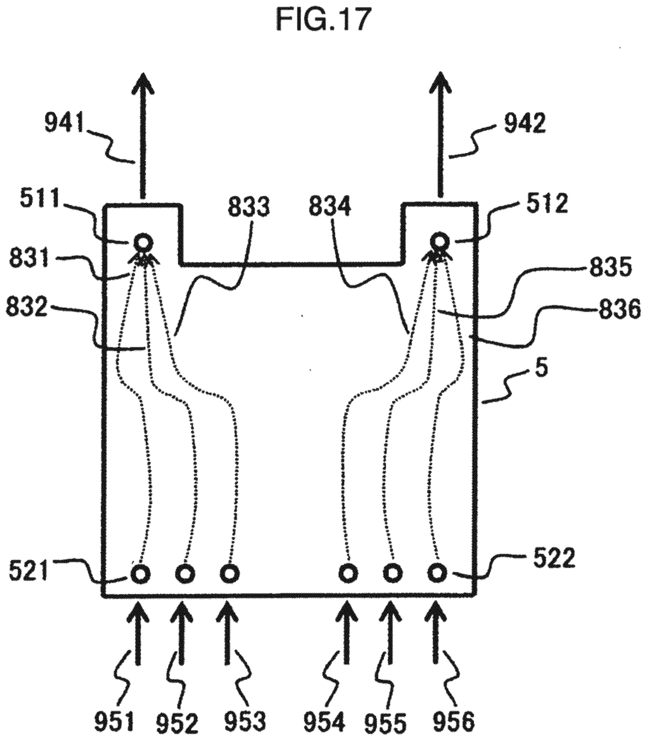

The N bus bar 5 as illustrated in FIG 17 includes terminals 511, 512 connected to the N-pole terminals 202, 203 of the smoothing capacitor 2 and terminals 521, 522 connected to the emitter terminals 102 of the switching modules 12, 14 as illustrated in FIG. 14. The terminals 5 11, 512 are disposed in a horizontally symmetrical manner, and in the present embodiment, the terminals 511, 512 are disposed at the outside of the bus bar. Portions of the electric current paths 831 to 836 of the N bus bar 5 extend along the electric current paths 811 to 816, 821 to 826 of the P bus bar 3 and the M bus bar 4 adjacent to each other.

In a section in which the paths extend, the magnetic fields formed by the bus bar electric currents cancel each other, so that the inductance of the path becomes substantially zero. The electric current has a property of more likely to flow in a path of which inductance is small. Therefore, the electric current paths 831 to 836 of the N bus bar 5 are formed as illustrated in FIG. 17.

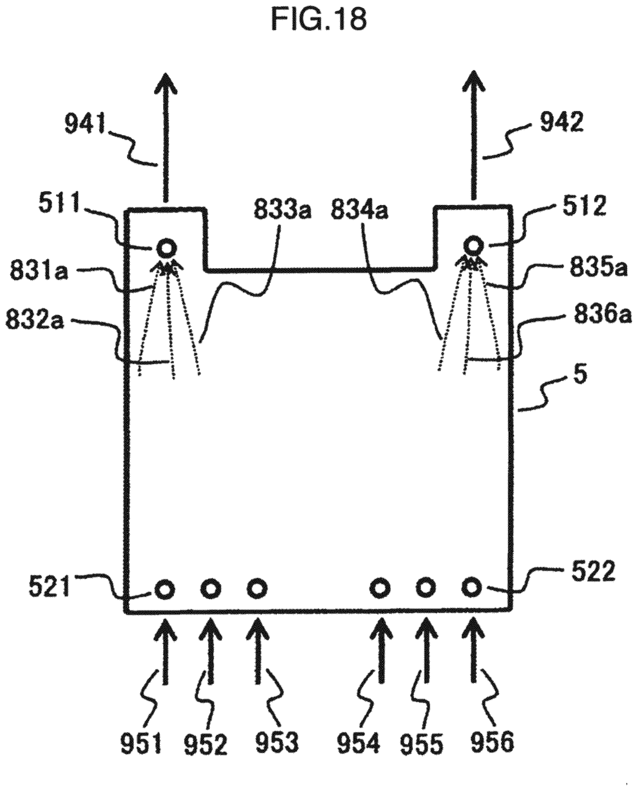

The substantive path contributing the inductance in the electric current paths 831 to 836 is given by subtracting a section in which the inductance becomes substantially zero. As illustrated in FIG. 18, the path lengths of the substantive paths 831a to 836a are substantially equal, and therefore, the magnitudes of the capacitor electric currents 941, 942 and the magnitudes of the switching module electric currents 951 to 956 can be made into substantially equal magnitudes.

As described above, the P bus bar 3, the M bus bar 4, and the N bus bar 5 described in the present embodiment are used, so that, even in a configuration in which four switching devices are connected in parallel, the distributions of the electric currents flowing in the switching modules 11 to 14 and the electric currents in the smoothing capacitor 2 can be equalized, and the electric power conversion apparatus having a higher degree of reliability can be provided.

In the present embodiment, the P bus bar and the M bus bar are disposed in the same plane, but the P bus bar and the M bus bar may not be necessarily disposed in the same plane. The P bus bar and the N bus bar are arranged in such an order that the P bus bar is disposed at the side closer to the switching modules, but the P bus bar and the N bus bar may be arranged in the opposite order.

In contrast to the present embodiment, the terminals 101, 102 of the switching modules 11 to 14 may be interchanged with each other, so that the P bus bar 3 may be used as the N bus bar, and the N bus bar 5 may be used as the P bus bar.

In the present embodiment, the switching module having three parallel switching devices is used. Alternatively, the switching module constituted by two parallel switching devices may be used.

### [Third embodiment]

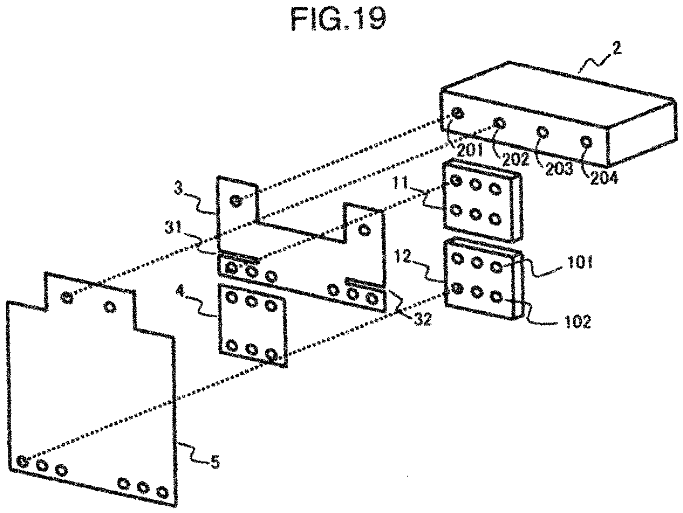

A single phase of an electric power conversion apparatus according to the present embodiment includes switching modules 11, 12, a smoothing capacitor 2, a P bus bar 3, an M bus bar 4, and an N bus bar 5 as illustrated in FIG 19. The difference from the first embodiment lies in that the configurations of the switching modules 11, 12 and the N bus bar 4 are different. In the following explanation, the issues common to the first embodiment will not be explained.

In the present embodiment, the upper arm of the circuit is constituted by the switching module 11, and the lower arm of the circuit is constituted by the switching module 12.

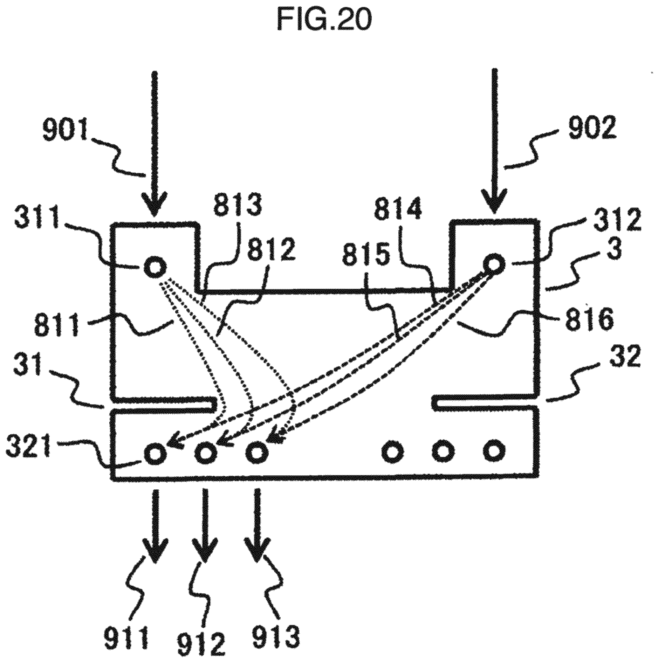

The P bus bar 3 as illustrated in FIG 20 has the same shape as the P bus bar 3 described in the first embodiment. The electric current paths 811 to 816 are different, and extend along the electric current paths 831 to 836 of the N bus bar 5 which are in proximity to portions of the paths.

In a section in which the paths extend, the magnetic fields formed by the bus bar electric currents cancel each other, so that the inductance of the path becomes substantially zero. The electric current has a property of more likely to flow in a path of which inductance is small. Therefore, the electric current paths 811 to 816 of the P bus bar 3 are formed as illustrated in the drawing.

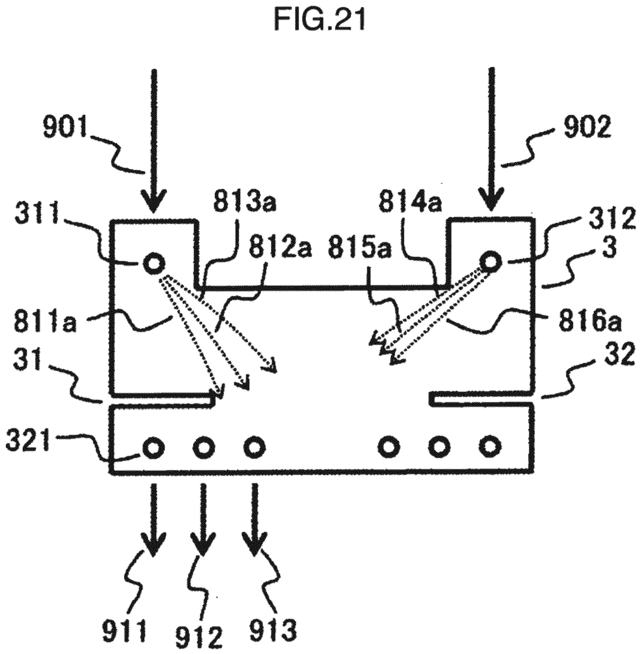

The substantive path of the electric current paths 811 to 816 is given by subtracting a section in which the inductance becomes substantially zero. As illustrated in FIG 21, the path lengths of the substantive paths 811a to 816a are substantially equal, and therefore, the magnitudes of the capacitor electric currents 901, 902 and the switching module electric currents 911 to 913 can be made into substantially equal magnitudes.

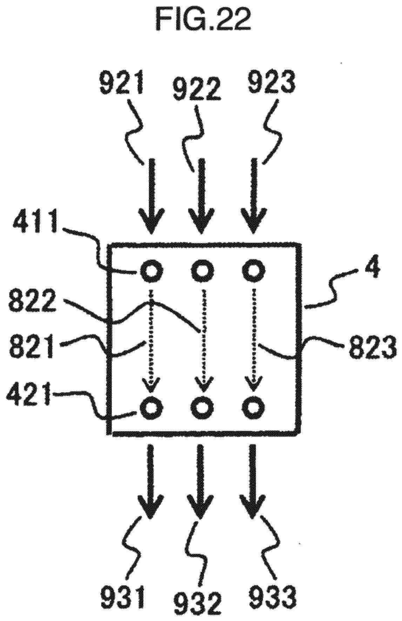

The M bus bar 4 as illustrated in FIG 22 includes terminals 411 connected to the emitter terminals 102 of the switching modules 11 and terminals 421 connected to the collector terminals 101 of the switching modules 12. In the M bus bar 5, the paths of the bus bar electric currents are denoted with 821 to 823, and the lengths become equal.

In a case where paths 827a, 828a from the terminal 411 to the terminal 421 are considered in FIG 10, these paths 827a, 828a have the same path length, and therefore, the exchange of the electric currents between terminals adjacent to each other in the horizontal direction is substantially zero. This indicates that any cross current does not occur in the horizontal direction between the terminal 411 and the terminal 421. This indicates that any cross current does not occur between terminals adjacent to each other in the horizontal direction. Therefore, the path between the terminal 411 and the terminal 421 are determined to be 821 to 823.

Therefore, the magnitudes of the switching module electric currents 921 to 923, 931 to 933 can be made into the same magnitude.

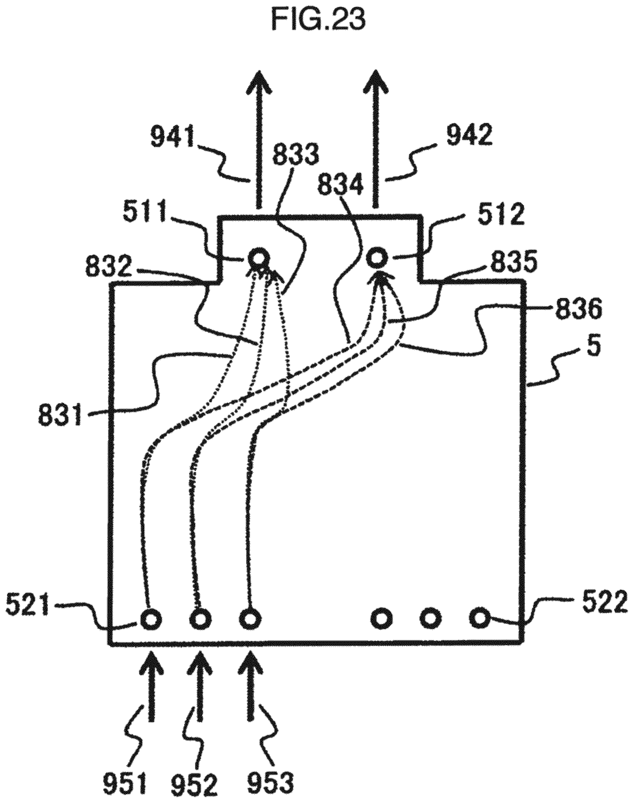

The N bus bar 5 as illustrated in FIG 23 has the same shape as the N bus bar 5 described in the first embodiment. The electric current paths 831 to 836 are different, and extend along the electric current paths 811 to 816 and 821 to 823 of the P bus bar 3 and the M bus bar 4 which are in proximity to portions of the paths.

In a section in which the paths extend, the magnetic fields formed by the bus bar electric currents cancel each other, so that the inductance of the path becomes substantially zero. The electric current has a property of more likely to flow in a path of which inductance is small. Therefore, the electric current paths 831 to 836 of the N bus bar 5 are formed as illustrated in the drawing.

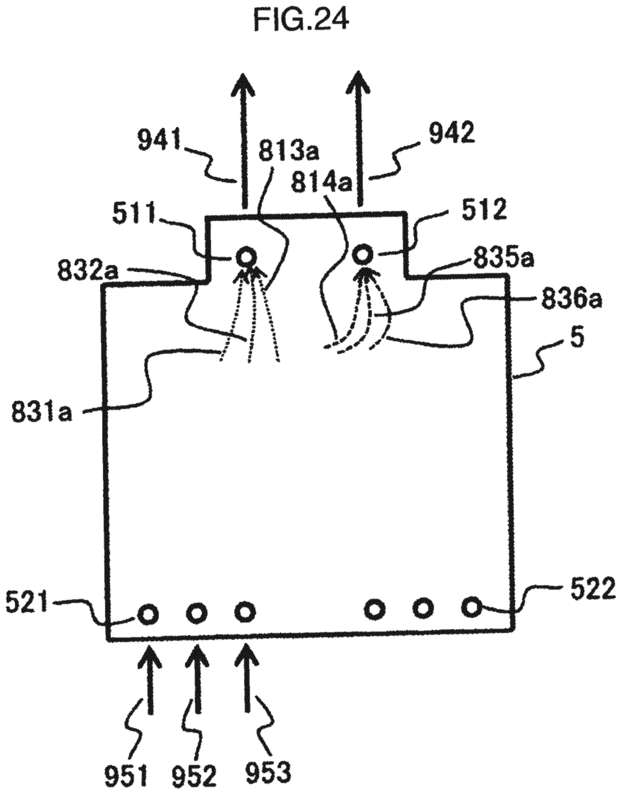

The substantive path of the electric current paths 831 to 836 is given by subtracting a section in which the inductance becomes substantially zero. As illustrated in FIG. 24, the path lengths of the substantive paths 831a to 836a are substantially equal, and therefore, the magnitudes of the capacitor electric currents 941, 942 and the switching module electric currents 951 to 953 can be made into substantially equal magnitudes.

As described above, the P bus bar 3, the M bus bar 4, and the N bus bar 5 described in the present embodiment are used, so that, even in a configuration in which three switching devices are connected in parallel, the distributions of the electric currents flowing in the switching modules 11, 12 and the electric currents in the smoothing capacitor 2 can be equalized, and the electric power conversion apparatus having a higher degree of reliability can be provided.

In the present embodiment, the P bus bar and the M bus bar are disposed in the same plane, but the P bus bar and the M bus bar may not be necessarily disposed in the same plane. The P bus bar and the N bus bar are arranged in such an order that the P bus bar is disposed at the side closer to the switching modules, but the P bus bar and the N bus bar may be arranged in the opposite order.

In contrast to the present embodiment, the terminals 101, 102 of the switching modules 11 to 14 may be interchanged with each other, so that the P bus bar 3 may be used as the N bus bar, and the N bus bar 5 may be used as the P bus bar.

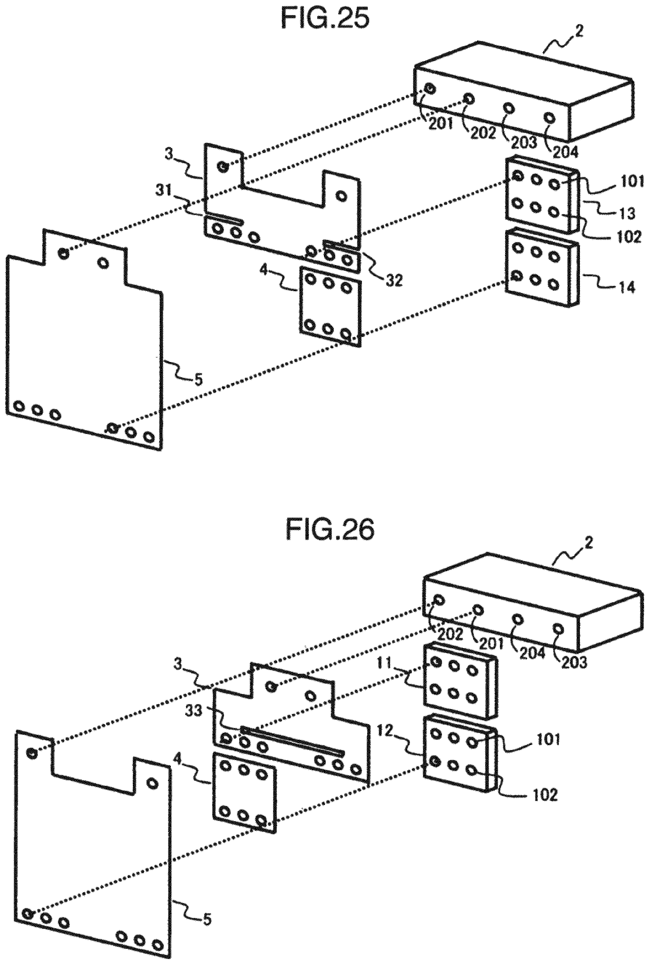

As illustrated in FIG. 25, the same effects can be obtained even in a configuration in which the switching modules 1 3,14 are used instead of the switching modules 1 1, 12, and these are connected to the M bus bar 4.

In the present embodiment, the switching module having three parallel switching devices is used. Alternatively, the switching module constituted by two parallel switching devices may be used.

### [Fourth embodiment]

A single phase of an electric power conversion apparatus according to the present embodiment includes switching modules 11, 12, a smoothing capacitor 2, a P bus bar 3, an M bus bar 4, and an N bus bar 5 as illustrated in FIG. 26. The difference from the second embodiment lies in that the configurations of the switching modules 11, 12 and the M bus bar 4 are different. In the following explanation, the issues common to the second embodiment will not be explained.

In the present embodiment, the upper arm of the circuit is constituted by the switching module 11, and the lower arm of the circuit is constituted by the switching module 12.

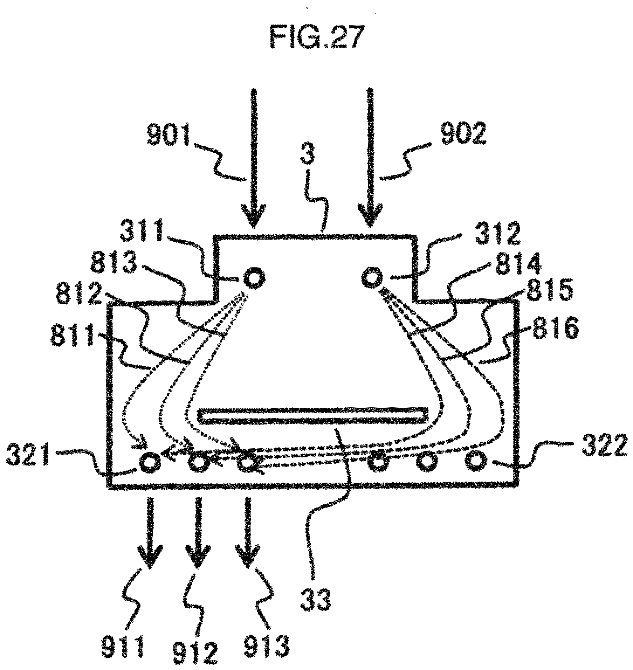

The P bus bar 3 as illustrated in FIG 27 has the same shape as the P bus bar 3 described in the second embodiment. The electric current paths 811 to 816 are different, and extend along the electric current paths 831 to 836 of the N bus bar 5 which are in proximity to portions of the paths.

In a section in which the paths extend, the magnetic fields formed by the bus bar electric currents cancel each other, so that the inductance of the path becomes substantially zero. The electric current has a property of more likely to flow in a path of which inductance is small. Therefore, the electric current paths 811 to 816 of the P bus bar 3 are formed as illustrated in the drawing.

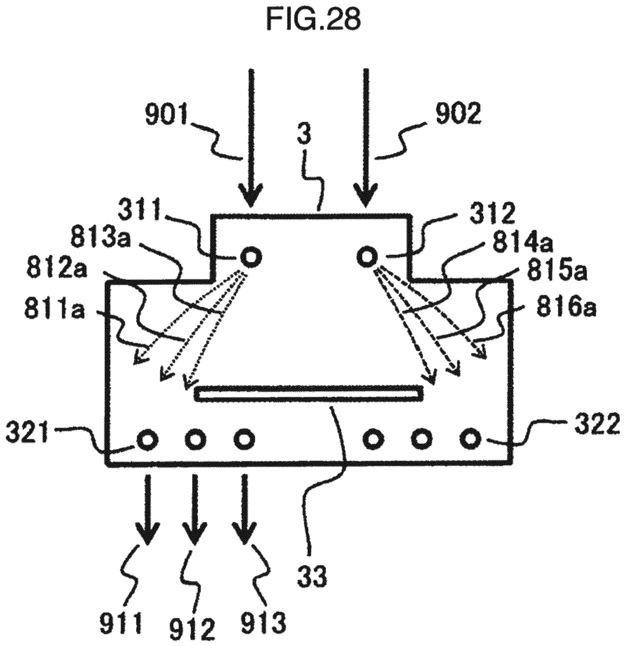

The substantive path of the electric current paths 811 to 816 is given by subtracting a section in which the inductance becomes substantially zero. As illustrated in FIG. 28, the path lengths of the substantive paths 811a to 816a are substantially equal, and therefore, the magnitudes of the capacitor electric currents 901, 902 and the switching module electric currents 911 to 913 can be made into substantially equal magnitudes.

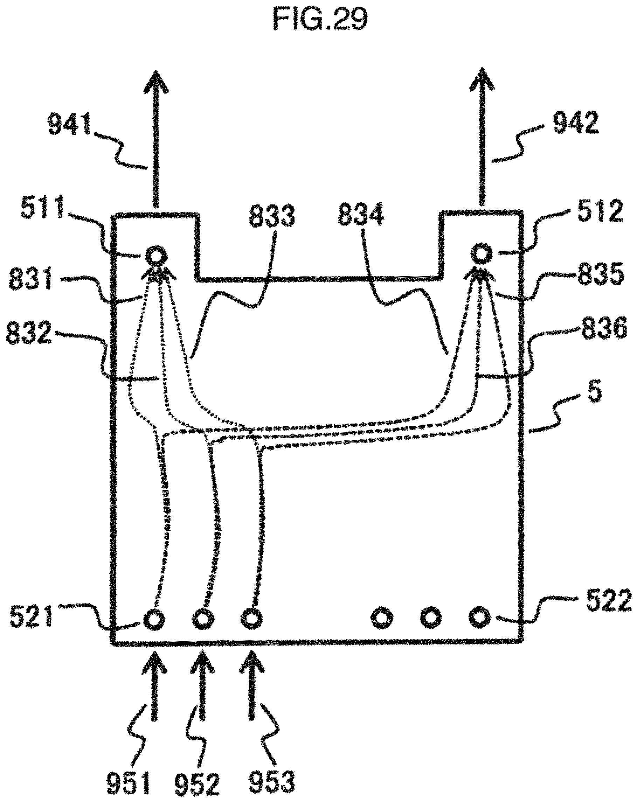

The N bus bar 5 as illustrated in FIG. 29 has the same shape as the N bus bar 5 described in the second embodiment. The electric current paths 831 to 836 are different, and extend along the electric current paths 811 to 816, 821 to 823 of the P bus bar 3 and the M bus bar 4 which are in proximity to portions of the paths.

In a section in which the paths extend, the magnetic fields formed by the bus bar electric currents cancel each other, so that the inductance of the path becomes substantially zero. The electric current has a property of more likely to flow in a path of which inductance is small. Therefore, the electric current paths 831 to 836 of the N bus bar 5 are formed as illustrated in the drawing.

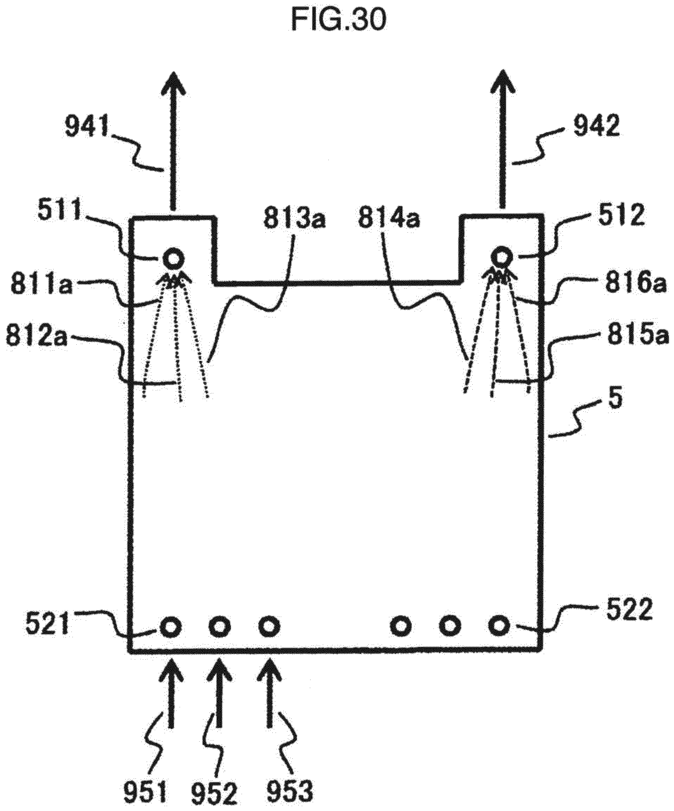

The substantive path of the electric current paths 831 to 836 is given by subtracting a section in which the inductance becomes substantially zero. As illustrated in FIG 30, the path lengths of the substantive paths 831a to 836a are substantially equal, and therefore, the magnitudes of the capacitor electric currents 941, 942 and the switching module electric currents 951 to 953 can be made into substantially equal magnitudes.

As described above, the P bus bar 3, the M bus bar 4, and the N bus bar 5 described in the present embodiment are used, so that, even in a configuration in which three switching devices are connected in parallel, the distributions of the electric currents flowing in the switching modules 11, 12 and the electric currents in the smoothing capacitor 2 can be equalized, and the electric power conversion apparatus having a higher degree of reliability can be provided.

In the present embodiment, the P bus bar and the M bus bar are disposed in the same plane, but the P bus bar and the M bus bar may not be necessarily disposed in the same plane. The P bus bar and the N bus bar are arranged in such an order that the P bus bar is disposed at the side closer to the switching modules, but the P bus bar and the N bus bar may be arranged in the opposite order.

In contrast to the present embodiment, the terminals 101, 102 of the switching modules 11 to 14 may be interchanged with each other, so that the P bus bar 3 may be used as the N bus bar, and the N bus bar 5 may be used as the P bus bar.

The same effects can be obtained even in a configuration in which the switching modules 13, 14 are used instead of the switching modules 11, 12, and these are connected to the M bus bar 4.

In the present embodiment, the switching module having three parallel switching devices is used. Alternatively, the switching module constituted by two parallel switching devices may be used.

## Claims

1. An electric power conversion apparatus in which an electric power conversion circuit for a single phase comprises:
a smoothing capacitor (2) for smoothing a direct current voltage, the smoothing capacitor (2) comprising a plurality of positive terminals (201, 204) and a plurality of negative terminals (202, 203);
parallel connected upper arm switching modules (11, 13) each comprising a plurality of first switching devices in parallel and a plurality of collector terminals (101) and a plurality of emitter terminals (102);
parallel connected lower arm switching modules (12, 14) each comprising a plurality of second switching devices in parallel and a plurality of collector terminals (101) and a plurality of emitter terminals (102);
a positive side bus bar (3) connected to the plurality of collector terminals of the upper arm switching modules (11, 13) and the plurality of positive side terminals (201, 204) of the smoothing capacitor (2);
an alternate current bus bar (4) connected to the plurality of emitter terminals of the upper arm switching modules (11, 13) and the plurality of collector terminals of the lower arm switching modules (12, 14); and
a negative side bus bar (5) connected to the plurality of the lower arm switching modules (12, 14) and the plurality of negative side terminals (202, 203) of the smoothing capacitor (2),
wherein:
bus bar terminals (311, 312) connected to the positive side terminals (201, 204) of the smoothing capacitor (2) are disposed at one side of, and in horizontally symmetrical positions on, the positive side bus bar (3);
a plurality of bus bar terminals (321, 322) connected to the collector terminals (101) of the upper arm switching modules (11, 13) are disposed at the other side of the positive side bus bar (3);
bus bar terminals (511, 512) connected to the negative side terminals (202, 203) of the smoothing capacitor (2) are disposed at one side of, and in horizontally symmetrical positions on, the negative side bus bar (5); and
a plurality of bus bar terminals (521, 522) connected to the emitter terminals (102) of the lower arm switching modules (12, 14) are disposed at the other side of the negative side bus bar (5);
among the bus bars (3, 4, 5), only the positive side bus bar (3) includes one or more slit units (31, 32, 33), said one or more slit units (31, 32, 33) being disposed in an area crossing a straight line which is the shortest among the straight lines connecting the terminal (311) connected to the positive side terminals (201, 204) of the smoothing capacitor (2), and each one of the plurality of terminals (321) connected to the upper arm switching modules (11, 13), and additionally in an area crossing a straight line which is the shortest among the straight lines connecting the terminal (312) connected to the positive side terminals (201, 204) of the smoothing capacitor (2), and each one of the terminals (322) connected to the upper arm switching modules (11, 13) such that the electric current path lengths (811-816) between the respective terminals on the positive bus bar (3) are made substantially equal; and
the positive side bus bar (3), the alternate current bus bar (4) and the negative side bus bar (5) are wide conductive bodies and arranged in proximity to each other such that the electric current paths (831-836) in the negative side bus bar (5) are made to extend along the electric current paths (811-816) in the positive side bus bar (3), as affected by the slit unit (31, 32) in the positive side bus bar (3), and are thereby made substantially equal.

2. The electric power conversion apparatus according to claim 1, wherein a plurality of terminals of the smoothing capacitor (2) include two terminals.

3. The electric power conversion apparatus according to claim 2, wherein the plurality of terminals of the upper arm and lower arm switching modules (11, 12, 13, 14) include two terminals or three terminals, and
the upper arm and lower arm switching modules (11, 12, 13, 14) are arranged in parallel to constitute upper and lower arms for a single phase of the electric power conversion circuit.

4. The electric power conversion apparatus according to claim 3, wherein the slit units (31, 32) are formed at positions at outsides having a symmetrical property on the positive side bus bar (3), and
the plurality of terminals connected to the smoothing capacitor (2) of the positive side bus bar (3) having the slit units (31, 32) are arranged at positions at an outside of the positive side bus bar (3).

5. The electric power conversion apparatus according to claim 3, wherein the slit unit (33) is formed at a position at an inside having a symmetrical property on the positive side bus bar (3), and
the terminal connected to the smoothing capacitor (2) of the positive side bus bar (3) having the slit unit (33) is arranged at an inside of the bus bar.

6. The electric power conversion apparatus according to claim 2, wherein the plurality of terminals of the upper arm and lower arm switching modules (11, 12, 13, 14) include two terminals or three terminals, and
a single upper arm switching module (11, 13) and a single lower arm switching module (12, 14) are arranged in parallel to constitute upper and lower arms for a single phase of the electric power conversion circuit.

7. The electric power conversion apparatus according to claim 6, wherein the slit units (31, 32) are formed at positions at outsides having a symmetrical property on the positive side bus bar (3), and
the terminal connected to the smoothing capacitor (2) of the positive side or negative side bus bar (3, 5) having the slit units (31, 32) is arranged at an outside of the positive side bus bar (3).

8. The electric power conversion apparatus according to claim 6, wherein the slit unit (33) is formed at a position at an inside having a symmetrical property on the positive side bus bar (3), and
the terminal connected to the smoothing capacitor (2) of the positive side bus bar (3) having the slit unit (33) is arranged at an inside of the bus bar.

## Patentansprüche

1. Elektrische Leistungsumwandlungsvorrichtung, worin eine elektrische Leistungsumwandlungsschaltung für eine Einzel-Phase Folgendes umfasst:
einen Glättungskondensator (2) zum Glätten einer Gleichspannung, wobei der Glättungskondensator (2) eine Vielzahl von positiven Anschlüssen (201, 204) und eine Vielzahl von negativen Anschlüssen (202, 203) umfasst;
parallel verbundene Oberer-Zweig-Schaltmodule (11, 13), die jeweils eine Vielzahl von parallel geschalteten, ersten Schaltvorrichtungen und eine Vielzahl von Kollektoranschlüssen (101) und eine Vielzahl von Emitteranschlüssen (102) umfassen;
parallel verbundene Unterer-Zweig-Schaltmodule (12, 14), die jeweils eine Vielzahl von parallel geschalteten, zweiten Schaltvorrichtungen und eine Vielzahl von Kollektoranschlüssen (101) und eine Vielzahl von Emitteranschlüssen (102) umfassen;
eine Positivseiten-Sammelschiene (3), die mit der Vielzahl von Kollektoranschlüssen der Oberer-Zweig-Schaltmodule (11, 13) und der Vielzahl von Positivseiten-Anschlüssen (201, 204) des Glättungskondensators (2) verbunden ist;
eine Wechselstrom-Sammelschiene (4), die mit der Vielzahl von Emitteranschlüssen der Oberer-Zweig-Schaltmodule (11, 13) und der Vielzahl von Kollektoranschlüssen der Unterer-Zweig-Schaltmodule (12, 14) verbunden ist; und
eine Negativseiten-Sammelschiene (5), die mit der Vielzahl der Unterer-Zweig-Schaltmodule (12, 14) und der Vielzahl von Negativseiten-Anschlüssen (202, 203) des Glättungskondensators (2) verbunden ist,
wobei Sammelschienenanschlüsse (311, 312), die mit den Positivseiten-Anschlüssen (201, 204) des Glättungskondensators (2) verbunden sind, an einer Seite der Positivseiten-Sammelschiene (3) und in horizontal symmetrischen Positionen auf derselben angeordnet sind;
wobei eine Vielzahl von Sammelschienenanschlüssen (321, 322), die mit den Kollektoranschlüssen (101) der Oberer-Zweig-Schaltmodule (11, 13) verbunden sind, an der anderen Seite der Positivseiten-Sammelschiene (3) angeordnet sind;
wobei Sammelschienenanschlüsse (511, 512), die mit den Negativseiten-Anschlüssen (202, 203) des Glättungskondensators (2) verbunden sind, an einer Seite der Negativseiten-Sammelschiene (5) und in horizontal symmetrischen Positionen derselben angeordnet sind; und
wobei eine Vielzahl von Sammelschienenanschlüssen (521, 522), die mit den Emitteranschlüssen (102) der Unterer-Zweig-Schaltmodule (12, 14) verbunden sind, an der anderen Seite der Negativseiten-Sammelschiene (5) angeordnet sind;
wobei von den Sammelschienen (3, 4, 5) lediglich die Positivseiten-Sammelschiene (3) eine oder mehrere Schlitzeinheiten (31, 32, 33) umfasst, wobei die eine oder die mehreren Schlitzeinheiten (31, 32, 33) in einem Bereich, der eine gerade Linie kreuzt, welche die kürzeste unter den geraden Linien ist, die den mit den Positivseiten-Anschlüssen (201, 204) des Glättungskondensators (2) verbundenen Anschluss (311) und jeden aus der Vielzahl von Anschlüssen (321), die mit den Oberer-Zweig-Schaltmodulen (11, 13) verbunden sind, verbindet, und darüber hinaus in einem Bereich angeordnet sind, der eine gerade Linie kreuzt, welche die kürzeste unter den geraden Linien ist, die den mit den Positivseiten-Anschlüssen (201, 204) des Glättungskondensators (2) verbundenen Anschluss (312) und jeden von den mit den Oberer-Zweig-Schaltmodulen (11, 13) verbundenen Anschlüssen (322) derart verbindet, dass die elektrischen Strompfadlängen (811 - 816) zwischen den jeweiligen Anschlüssen auf der positiven Sammelschiene (3) im Wesentlichen gleich ausgeführt sind; und
wobei die Positivseiten-Sammelschiene (3), die Wechselstrom-Sammelschiene (4) und die Negativseiten-Sammelschiene (5) breite leitfähige Körper und derart nahe beieinander angeordnet sind, dass die elektrischen Strompfade (831-836) in der Negativseiten-Sammelschiene (5) so ausgelegt sind, dass sie sich, so wie in der Positivseiten-Sammelschiene durch die Schlitzeinheit (31, 32) beeinflusst, entlang der elektrischen Strompfade (811-816) in der Positivseiten-Sammelschiene (3) erstrecken, und dadurch im Wesentlichen gleich ausgeführt sind.

2. Elektrische Leistungsumwandlungsvorrichtung gemäß Anspruch 1, wobei eine Vielzahl von Anschlüssen des Glättungskondensators (2) zwei Anschlüsse umfasst.

3. Elektrische Leistungsumwandlungsvorrichtung gemäß Anspruch 2,
wobei die Vielzahl von Anschlüssen der Oberer-Zweig- und der Unterer-Zweig-Schaltmodule (11, 12, 13, 14) zwei Anschlüsse oder drei Anschlüsse umfasst, und
wobei die Oberer-Zweig- und die Unterer-Zweig-Schaltmodule (11, 12, 13, 14) parallel angeordnet sind, um obere und untere Zweige für eine Einzel-Phase der elektrischen Leistungsumwandlungsschaltung zu bilden.

4. Elektrische Leistungsumwandlungsvorrichtung gemäß Anspruch 3,
wobei die Schlitzeinheiten (31, 32) an Positionen an Außenseiten, die eine symmetrische Eigenschaft aufweisen, auf der Positivseiten-Sammelschiene (3) ausgebildet sind, und
wobei die Vielzahl von Anschlüssen, die mit dem Glättungskondensator (2) der Positivseiten-Sammelschiene (3), welche die Schlitzeinheiten (31, 32) aufweist, verbunden sind, an Positionen an einer Außenseite der Positivseiten-Sammelschiene (3) angeordnet ist.

5. Elektrische Leistungsumwandlungsvorrichtung gemäß Anspruch 3,
wobei die Schlitzeinheit (33) an einer Position an einer Innenseite, die eine symmetrische Eigenschaft aufweist, auf der Positivseiten-Sammelschiene (3) ausgebildet ist, und
wobei der mit dem Glättungskondensator (2) der Positivseiten-Sammelschiene (3), welche die Schlitzeinheit (33) aufweist, verbundene Anschluss an einer Innenseite der Sammelschiene angeordnet ist.

6. Elektrische Leistungsumwandlungsvorrichtung nach Anspruch 2,
wobei die Vielzahl von Anschlüssen der Oberer-Zweig- und der Unterer-Zweig-Schaltmodule (11, 12, 13, 14) zwei Anschlüsse oder drei Anschlüsse umfassen, und
wobei ein Einzel-Oberer-Zweig-Schaltmodul (11, 13) und ein Einzel-Unterer-Zweig-Schaltmodul (12, 14) parallel angeordnet sind, um obere und untere Zweige für eine Einzel-Phase der elektrischen Leistungsumwandlungsschaltung zu bilden.

7. Elektrische Leistungsumwandlungsvorrichtung nach Anspruch 6,
wobei die Schlitzeinheiten (31, 32) an Positionen an Außenseiten, die eine symmetrische Eigenschaft aufweisen, auf der Positivseiten-Sammelschiene (3) ausgebildet sind, und
wobei der mit dem Glättungskondensator (2) der Positivseiten- oder der Negativseiten-Sammelschiene (3, 5), welche die Schlitzeinheiten (31, 32) aufweisen, verbundene Anschluss an einer Außenseite der Positivseiten-Sammelschiene (3) angeordnet ist.

8. Elektrische Leistungsumwandlungsvorrichtung nach Anspruch 6,
wobei die Schlitzeinheit (33) an einer Position an einer Innenseite, die eine symmetrische Eigenschaft aufweist, auf der Positivseiten-Sammelschiene (3) ausgebildet ist, und
wobei der mit dem Glättungskondensator (2) der Positivseiten-Sammelschiene (3), welche die Schlitzeinheit (33) aufweist, verbundene Anschluss an einer Innenseite der Sammelschiene angeordnet ist.

## Revendications

1. Appareil de conversion de puissance électrique dans lequel un circuit de conversion de puissance électrique pour une seule phase comprend :
un condensateur de lissage (2) pour lisser une tension continue, le condensateur de lissage (2) comprenant une pluralité de bornes positives (201, 204) et une pluralité de bornes négatives (202, 203) ;
des modules de commutation de bras supérieur connectés en parallèle (11, 13) comprenant chacun une pluralité de premiers dispositifs de commutation en parallèle et une pluralité de bornes collectrices (101) et une pluralité de bornes émettrices (102) ;
des modules de commutation de bras inférieur connectés en parallèle (12, 14) comprenant chacun une pluralité de seconds dispositifs de commutation en parallèle et une pluralité de bornes collectrices (101) et une pluralité de bornes émettrices (102) ;
une barre omnibus côté positif (3) connectée à la pluralité de bornes collectrices des modules de commutation de bas supérieur (11, 13) et à la pluralité de bornes côté positif (201, 204) du condensateur de lissage (2) ;
une barre omnibus de courant alternatif (4) connectée à la pluralité de bornes émettrices des modules de commutation de bras supérieur (11, 13) et à la pluralité de bornes collectrices des modules de commutation de bras inférieur (12, 14) ; et
une barre omnibus côté négatif (5) connectée à la pluralité de modules de commutation de bras inférieur (12, 14) et à la pluralité de bornes côté négatif (202, 203) du condensateur de lissage (2),
dans lequel :
les bornes de barre omnibus (311, 312) connectées aux bornes côté positif (201, 204) du condensateur de lissage (2) sont disposées sur un côté de la barre omnibus côté positif (3) et dans des positions horizontalement symétriques sur celle-ci ;
une pluralité de bornes de barre omnibus (321, 322) connectées aux bornes collectrices (101) des modules de commutation de bras supérieur (11, 13) sont disposées sur l'autre côté de la barre omnibus côté positif (3) ;
des bornes de barre omnibus (511, 512) connectées aux bornes côté négatif (202, 203) du condensateur de lissage (2) sont disposées sur un côté de la barre omnibus côté négatif (5) et à des positions horizontalement symétriques sur celle-ci ; et
une pluralité de bornes de barre omnibus (521, 522) connectées aux bornes émettrices (102) des modules de commutation de bras inférieur (12, 14) sont disposées sur l'autre côté de la barre omnibus côté négatif (5) ;
parmi les barres omnibus (3, 4, 5), seule la barre omnibus côté positif (3) inclut une ou plusieurs unités à fente (31, 32, 33), lesdites une ou plusieurs unités à fente (31, 32, 33) étant disposées dans une zone croisant une ligne droite qui est la plus courte parmi les lignes droites reliant la borne (311) connectée aux bornes côté positif (201, 204) du condensateur de lissage (2), et
chacune de la pluralité de bornes (321) connectées aux modules de commutation de bras supérieur (11, 13), et par ailleurs dans une zone croisant une ligne droite qui est la plus courte parmi les lignes droites reliant la borne (312) connectée aux bornes côté positif (201, 204) du condensateur de lissage (2), et chacune des bornes (322) connectées aux modules de commutation de bras supérieur (11, 13) de telle sorte que les longueurs de trajet de courant électrique (811-816) entre les bornes respectives sur la barre omnibus positive (3) sont rendues sensiblement égales ; et
la barre omnibus côté positif (3), la barre omnibus de courant alternatif (4) et la barre omnibus côté négatif (5) sont des corps conducteurs larges et agencés à proximité les uns des autres de telle sorte que les trajets de courant électrique (831-836) dans la barre omnibus côté négatif (5) sont amenés à s'étendre le long des trajets de courant électrique (811-816) dans la barre omnibus côté positif (3), comme affecté par l'unité à fente (31, 32) dans la barre omnibus côté positif (3), et sont ainsi rendus sensiblement égaux.

2. Appareil de conversion de puissance électrique selon la revendication 1, dans lequel une pluralité de bornes du condensateur de lissage (2) inclut deux bornes.

3. Appareil de conversion de puissance électrique selon la revendication 2, dans lequel la pluralité de bornes des modules de commutation de bras supérieur et de bras inférieur (11, 12, 13, 14) inclut deux bornes ou trois bornes, et
les modules de commutation de bras supérieur et de bras inférieur (11, 12, 13, 14) sont agencés en parallèle pour constituer des bras supérieur et inférieur pour une seule phase du circuit de conversion de puissance électrique.

4. Appareil de conversion de puissance électrique selon la revendication 3, dans lequel les unités à fente (31, 32) sont formées à des positions sur des surfaces extérieures ayant une propriété symétrique sur la barre omnibus côté positif (3), et
la pluralité de bornes connectées au condensateur de lissage (2) de la barre omnibus côté positif (3) ayant les unités à fente (31, 32) sont agencées à des positions sur une surface extérieure de la barre omnibus côté positif (3).

5. Appareil de conversion de puissance électrique selon la revendication 3, dans lequel l'unité à fente (33) est formée à une position sur une surface intérieure ayant une propriété symétrique sur la barre omnibus côté positif (3),
et
la borne connectée au condensateur de lissage (2) de la barre omnibus côté positif (3) ayant l'unité à fente (33) est agencée sur une surface intérieure de la barre omnibus.

6. Appareil de conversion de puissance électrique selon la revendication 2, dans lequel la pluralité de bornes des modules de commutation de bras supérieur et de bras inférieur (11, 12, 13, 14) incluent deux bornes ou trois bornes, et
un seul module de commutation de bras supérieur (11, 13) et un seul module de commutation de bras inférieur (12, 14) sont agencés en parallèle pour constituer des bras supérieur et inférieur pour une seule phase du circuit de conversion de puissance électrique.

7. Appareil de conversion de puissance électrique selon la revendication 6, dans lequel les unités à fente (31, 32) sont formées à des positions sur les surfaces extérieures ayant une propriété symétrique sur la barre omnibus côté positif (3), et
la borne connectée au condensateur de lissage (2) de la barre omnibus côté positif ou côté négatif (3, 5) ayant les unités à fente (31, 32) est agencée sur une surface extérieure de la barre omnibus côté positif (3).

8. Appareil de conversion de puissance électrique selon la revendication 6, dans lequel l'unité à fente (33) est formée à une position sur une surface intérieure ayant une propriété symétrique sur la barre omnibus côté positif (3),
et
la borne connectée au condensateur de lissage (2) de la barre omnibus côté positif (3) ayant l'unité à fente (33) est agencée sur une surface intérieure de la barre omnibus.
